Europäisches Patentamt

European Patent Office

Office européen des brevets

(11) Veröffentlichungsnummer: **0 370 576**
**A2**

(12) **EUROPÄISCHE PATENTANMELDUNG**

(21) Anmeldenummer: **89202939.8**

(51) Int. Cl.5: **H03K 3/283**

(22) Anmeldetag: **20.11.89**

(30) Priorität: **24.11.88 DE 3839658**

(43) Veröffentlichungstag der Anmeldung:
**30.05.90 Patentblatt 90/22**

(84) Benannte Vertragsstaaten:
**AT CH DE FR GB IT LI**

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **CH FR GB IT LI AT**

(72) Erfinder: **Peters, Matthias**
**Altonaer Strasse 348a**
**D-2083 Halstenbek(DE)**

(74) Vertreter: **Kupfermann, Fritz-Joachim,**
**Dipl.-Ing. et al**
**Philips Patentverwaltung GmbH**
**Wendenstrasse 35 Postfach 10 51 49**
**D-2000 Hamburg 1(DE)**

(54) **Oszillator.**

(57) Oszillator mit mindestens zwei in Wechselwirkung stehenden Transistoren (17, 18), deren Kollektoren über je einen von zwei gleichen Kollektorwiderständen (19, 20) an den positiven Pol und deren Emitter über je einen von zwei gleichen Emitterwiderständen (21, 22) an den negativen Pol einer Gleichspannungsquelle $U_V$ angeschlossen sind, deren Kollektoren ferner mit der Basis des jeweils anderen Transistors (17, 18) verbunden sind und am Emitter des einen Transistors (17) und parallel zum entsprechenden Emitterwiderstand (21) ein Schwingquarz (12) oder ein Serienschwingkreis angeordnet ist, wobei am Emitter des anderen Transistors (18) und parallel zum entsprechenden Emitterwiderstand (22) eine Treiberschaltung (23) für eine auskoppelbare Oszillatorspannung für eine externe niederohmige stark kapazitive Last angeschlossen ist.

## Oszillator

Die Erfindung betrifft einen Oszillator nach dem Oberbegriff des Patentanspruches 1.

Oszillatoren sind bekannt. So ist aus dem Buch Tietze/Schenk "Halbleiter-Schaltungstechnik" Springer Verlag, 8. Auflage, Seite 451, ein emittergekoppelter Oszillator bekannt. Dieser Oszillator weist zwei Transistoren auf, die über je einen Kollektorwiderstand an den positiven Pol einer Gleichstromquelle und über je einen Emitterwiderstand an den anderen Pol der Gleichstromquelle angeschlossen sind. Jeder Kollektor ist mit der Basis des anderen Transistors verbunden. Zwischen den Emittern der Transistoren ist ein Schwingquarz angeordnet. Dieser Oszillator benötigt zwar eine geringe Chipfläche, sofern er in integrierter Schaltungstechnik aufgebaut ist, muß dann jedoch zwei Anschlußpins bzw. herausgeführte Anschlüsse für den Schwingquarz aufweisen. Ferner ist nur eine hochohmige externe Last möglich, da die Oszillatorspannung nur an den Kollektoren der Transistoren abgenommen werden kann.

Aus der DE-OS 31 04 849 ist ein Quarzoszillator mit einem Anschlußpin für einen Schwingquarz, zwei Transistorpaaren und einem als Emitterfolger geschalteten Transistor für den Anschluß an eine Versorgungsspannung bekannt. Dem als emittergeschalteten Transistor ist ein Vorspannungserzeuger mit einer Reihendiodenschaltung o.dgl. vorgeschaltet. Die Kollektoren des einen Transistorpaares sind über je eine Kollektorimpedanz mit dem Emitter des der Versorgung dienenden Transistors verbunden und mit je einer Basis eines Transistors des anderen Transistorpaares, deren Kollektoren ebenfalls an dem Emitter des der Versorgung dienenden Transistors angeschlossen sind. Zwischen den Emittern dieses Transistorpaares kann die Oszillatorspannung abgegriffen werden. Diese Emitter sind weiter jeweils an eine Basis eines Transistors des vorgenannten Transistorspaares angeschlossen, deren Emitter je eine mit dem negativen Pol der Versorgungsspannung verbundenen Emitterimpedanz aufweisen. Der einen Emitterimpedanz ist ein Kondensator parallel geschaltet und der anderen eine Reihenschaltung aus einem Schwingquarz und einem Kondensator. Obgleich dieser Oszillator, wenn er in integrierter Schaltungstechnik aufgebaut ist, bereits nur einen Anschlußpin für den Schwingquarz benötigt, so ist die Schaltung u.a. sehr aufwendig, nicht geeignet, ohne zusätzliche Ausgangstreiberstufe eine externe Last zu treiben, benötigt wegen der Vielzahl von Bauelementen eine entsprechend große Chipfläche und weist, wie Versuche gezeigt haben, relativ große Frequenzänderungen in Abhängigkeit der Versorgungsspannung auf.

Der vorliegenden Erfindung liegt die Aufgabe zugrunde, einen Oszillator mit nur einem Anschlußpin für einen Schwingquarz oder ein anderes frequenzbestimmendes Element zu schaffen, der eine Schaltung aufweist, die einfach aufgebaut ist, eine geringe Chipfläche benötigt, einen weitgehend impedanzunabhängigen Ausgang für eine externe Last aufweist und deren Frequenzänderung in Abhängigkeit von einer Versorgungsspannungsänderung gering ist.

Diese Aufgabe wird durch den kennzeichnenden Teil des Patentanspruches 1 gelöst.

Gemäß einer vorteilhaften Ausgestaltung der Erfindung ist vorgesehen, daß eine Treiberschaltung mit einem Eingang mit dem genannten, nicht invertierenden Ausgang zum Aus koppeln eines weiteren Oszillatorsignals verbunden ist, ferner, daß das frequenzbestimmende Element vorzugsweise einen Schwingquarz, einen LC-Schwingkreis o. dgl. enthält. Vorteilhaft ist desweiteren vorgesehen, daß für jeden der Invertierer ein Quotient aus dem mit dem invertierenden und dem mit dem nicht-invertierenden Ausgang verbundenen Widerstand kleiner als eins ist.

Der erfindungsgemäße Oszillator ermöglicht den Betrieb mit einem einseitig geerdeten Schwingquarz. Die Schaltung des Oszillators mit zwei unmittelbar kreuzgekoppelten Invertierern weist im wesentlichen zwei Transistoren auf, die jeweils mit einem Kollektorwiderstand und einem Emitterwiderstand beschaltet sind und jeweils einen Verstärker mit einer Phasendrehung bilden. Der jeweilige Verstärkungsfaktor ergibt sich näherungsweise aus dem Verhältnis von Kollektorwiderstand zu Emitterwiderstand. Erfindungsgemäß müssen die entsprechenden Widerstände derart gewählt werden, daß der Quotient aus Kollektorwiderstand und Emitterwiderstand immer kleiner 1 ist.

Die Basis eines jeden Transistors bildet den Eingang des entsprechenden Verstärkers und der Kollektor den Ausgang des Verstärkers. Werden die Verstärker bzw. die Transistoren in einer Schaltung von links nach rechts durchnummeriert, dann ist der Ausgang, also der Kollektor des zweiten Transistors, auf den Eingang, also die Basis des ersten Transistors rückgekoppelt. Umgekehrt ist der Ausgang des ersten Verstärkers, also der Kollektor des ersten Transistors auf den Ausgang des zweiten Verstärkers, also die Basis des zweiten Transistors rückgekoppelt. Parallel zum ersten Emitterwiderstand ist der Schwingquarz geschaltet. Er weist entsprechend einer allgemein bekannten Ersatzschaltung einen Serienverlustwiderstand auf. Dieser liegt dann auch Parallel zum genannten Emitterwiderstand. Bei geeigneter Wahl der Kollektor- und Emitterwidestände beider Transistoren hat sich gezeigt, daß eine Schwingung möglich ist, ohne daß beide Verstärker die gleiche Verstärkung aufweisen.

Dies resultiert im wesentlichen daraus, daß die Gesamtverstärkung, die im Fall der Schwingungsentfachung größer 1 sein muß, durch das Produkt eines Quotienten aus dem Kollektorwiderstand des ersten Transistors und dem Serienverlustwiderstand des Schwingquarzes und einem Quotienten aus dem Kollektor- und Emitterwiderstand des zweiten Transistors erfüllt ist.

Um die Frequenz des Quarzoszillators in einem kleinen Bereich variieren zu können, um sie z.B. exakt auf einen gewünschten Wert einzustellen, kann vorgesehen sein, daß in Reihe mit dem Schwingquarz ein Kondensator mit variabler Kapazität geschaltet ist, dessen Kapazität groß gegenüber der des Schwingquarzes ist.

Diese wenige Bauelemente aufweisende Schaltung eines erfindungsgemäßen Quarzoszillators ist bereits zur Auskopplung einer Oszillatorspannung für eine niederohmige externe Last geeignet. Dies resultiert im wesentlichen daraus, daß der zweite Transistor quasi als Emitterfolger beschaltet ist, so daß über seinem Emitterwiderstand eine Oszillatorspannung für eine niederohmige Last abgegriffen werden kann.

Ist darüber hinaus die externe Last stark kapazitiv, d.h. mit einer wechselstrommäßig niederohmigen Impedanz behaftet, dann ist erfindungsgemäß eine Treiberschaltung mit einem weiteren Transistor vorgesehen. Die Basis dieses weiteren Transistors ist mit dem Emitter des zweiten Transistors verbunden. Sein Kollektor ist mit der Betriebsspannung verbunden. An seinem Emitter, der mit einem Emitterwiderstand beschaltet ist, kann eine Oszillatorspannung für eine externe niederohmige und stark kapazitive Last abgegriffen werden. Der Widerstandswert dieses Emitterwiderstandes wird geeigneterweise so dimensioniert, daß sich für den Transistor ein Arbeitspunkt in der Weise einstellt, daß der dynamische Emitterausgangswiderstand genügend niederohmig, d.h. in der Regel nicht größer als der Widerstand der Last ist, um die Last treiben zu können.

Diese weitere Auskopplungsmöglichkeit der Oszillatorspannung kann z.B. in vorteilhafter Weise genutzt werden, um gleichzeitig zwei Lasten zu treiben, wobei sich die Lasten sogar voneinander unterscheiden können.

Diese insgesamt wenige Bauelemente aufweisende Schaltung eines Quarzoszillators ist für eine Spannungsversorgung von wenigen Volt bis über 10 Volt geeignet. Im Stand der Technik sind häufig wesentlich höhere Versorgungsspannungen notwendig. So ist für den schaltungstechnisch überaus aufwendigen Quarzoszillator nach der bereits genannten DE-OS 31 04 849 eine Versorgungsspannung von mehr als 10 Volt vorzusehen. Dieser aufwendigere Quarzoszillator ist darüber hinaus nur geeignet für eine Signalverarbeitung innerhalb eines IC's, d.h. für den Fall, daß eine externe Last versorgt werden soll, ist in jedem Fall eine zusätzliche Ausgangstreiberstufe notwendig.

An dieser Stelle sei darauf hingewiesen, daß der Oszillator nicht nur zum Anschluß eines Schwingquarzes geeignet ist, sondern daß anstelle eines Schwingquarzes auch ein Keramikschwingkreis, bzw. ein LC-Serienschwingkreis o.dgl. vorgesehen sein kann.

Bei dem erfindungsgemäßen Quarzoszillator hat sich ferner gezeigt, daß die Abhängigkeit der Frequenzänderung von der Versorgungsspannung überaus gering ist. Bei z.B. 13 MHz beträgt die Änderung nur ca. 1 KHz pro Volt.

Weitere bevorzugte Ausgestaltungen des vorliegenden Quarzoszillators ergeben sich aus den Unteransprüchen.

Ein Ausführungsbeispiel der Erfindung wird nachfolgend unter Bezugnahme auf eine Zeichnung näher erläutert.

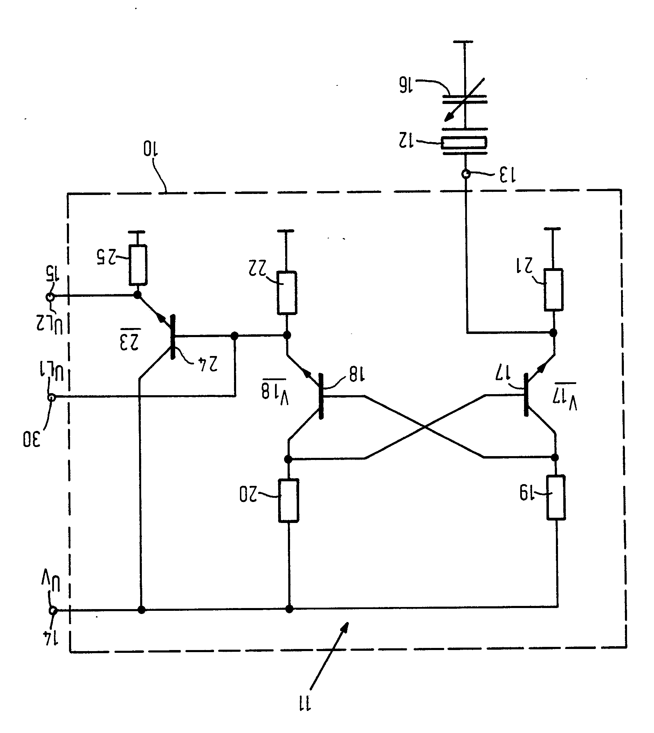

Die Zeichnung zeigt einen Block 10, durch den angedeutet ist, daß die in dem Block 10 befindliche Schaltung 11 des Oszillators bzw. Oszillatorschaltung in integrierter Schaltungstechnik ausgeführt werden kann. Für den Anschluß eines Schwingquarzes 12 ist nur ein zusätzlicher äußerer Anschluß 13 erforderlich. Die weiteren aus dem Block 10 herausgeführten Anschlüsse 14, 15 und 30 dienen zum einen der Versorgungsspannung $U_V$ der Oszillatorschaltung 11 und zum anderen der Auskopplung der Oszillatorspannungen $U_{L1}$, $U_{L2}$, um externe Lasten, so auch eine externe z.B. niederohmige und stark kapazitive Last, d.h. eine Last mit einer wechselspannungsmäßig niederohmigen Impedanz anzuschließen. In der Zeichnung ist eine solche Last nicht dargestellt.

Außerhalb des Blockes 10 und in Reihe zum Schwingquarz 12 kann ein in seiner Kapazität veränderbarer Kondensator 16 gegen Masse angeordnet sein. Dieser Kondensator 16 dient dazu, die Frequenz des Quarzoszillators in einem kleinen Bereich zu variieren, um sie exakt auf einen gewünschten Wert einstellen zu können. Die Kapazität dieses Kondensators 16 muß dabei groß gegenüber der Kapazität des Schwingquarzes sein.

Die Oszillatorschaltung 11 weist zwei Transistoren 17 und 18 mit Kollektorwiderständen 19 und 20 und Emitterwiderständen 21 und 22 auf. Die Kollektorwiderstände 19 und 20 entsprechen einander und sind mit dem Anschluß 14 und somit mit dem positiven Pol der Versorgungsspannung $U_V$ verbunden. Die Emitterwiderstände 21 und 22 entsprechen ebenfalls einander und sind gegen Masse geschaltet. Die Dimensionierung der Widerstände muß derart gewählt sein, daß der Quotient aus Kollektorwiderstand und Emitterwiderstand kleiner 1 ist. Nach einer beispielhaften Realisierung, auf die auch alle folgenden nummerisch angegebenen Dimensionierungswerte bezogen sind, ergibt sich dieser Quotient zu 0,5. Die Transistoren 17 und 18 bilden zusammen mit den entsprechenden Kollektor- und Emitterwiderständen jeweils einen Verstärker mit 180° Phasendrehung. Der jeweilige Verstärkungsfaktor wird in grober Näherung durch den Quotienten aus Kollektorwiderstand zu Emitterwiderstand bestimmt. An dieser Stelle sei vermerkt, daß der erfindungsgemäße Quarzoszillator mit npn-Transistoren aufgebaut ist. Bei Verwendung von pnp-Transistoren kehren alle Spannungen und Ströme ihr Vorzeichen um.

Der Transistor 17 bildet eine Verstärkerstufe $V_{17}$ und der Transistor 18 eine Verstärkerstufe $V_{18}$. Der Ausgang der Verstärkerstufe $V_{18}$ wird auf den Eingang der Verstärkerstufe $V_{17}$ rückgekoppelt. Umgekehrt wird der Ausgang der Verstärkerstufe $V_{17}$ auf den Eingang der Verstärkerstufe $V_{18}$ rückgekoppelt. Der Ausgang der Verstärkerstufe $V_{17}$ ist der Kollektor des Transistors 17 und der Eingang wird durch die Basis dieses Transistors 17 gebildet. Der Ausgang der Verstärkerstufe $V_{18}$ entspricht dem Kollektor von Transistor 18 und der Eingang seiner Basis. Die Gesamtverstärkung ist dann $\overline{V} = V_{17} V_{18}$, also das Produkt aus den beiden Verstärkungen. Die Bedingung für eine Schwingungsentfachung lautet k V = 1, wobei hier k = 1 ist und $V = (-0,5) (\overline{-0,5}) = 0,25$ (ohne $\overline{S}$chwingquarz). D.h. ohne Schwingquarz bzw. LC-Schwingkreis, ist eine Schwingung nicht möglich. Erst durch die zusätzliche Verbindung des Anschlußes 13 mit dem Emitter des Transistors 17, also des Anschlußes des Schwingquarzes, ist eine Schwingung möglich. Im Fall der Serienresonanz des Schwingquarzes ist nämlich nur der nicht dargestellte Serienverlustwiderstand wirksam. Er liegt parallel zum Emitterwiderstand 21. Entsprechend der beispielhaft angegebenen Dimensionierung weisen die Emitterwiderstände 21 und 22 einen Widerstandswert von 6 kOhm und die Kollektorwiderstände 19, 20 einen von 3 kOhm auf. Der Emitterwiderstand 21 ist somit in der Regel sehr viel größer als der nur etwa 100 Ohm aufweisende Serienverlustwiderstand. Hierdurch kann die Parallelschaltung aus dem Emitterwiderstand 21 und dem Serienverlustwiderstand näherungsweise durch den Serienverlustwiderstand im Fall der Serienresonanz ersetzt werden. Die Gesamtverstärkung $\underline{V}$ ist dann im Fall der Serienresonanz näherungsweise aus dem Produkt der Quotienten aus dem Kollektorwiderstand 19 und dem Serienverlustwiderstand sowie dem Kollektorwiderstand 20 und dem Emitterwiderstand 22 zu bilden. Die in dieser Gleichung negativen Vorzeichen der Kollektorwiderstände multiplizieren sich heraus, so daß die Gesamtverstärkung in jedem Fall größer 1 ist, womit die Schwingungsbedingung erfüllt ist.

Eine Auskopplung der Oszillatorspannung $U_{L1}$ ist bereits am Emitter des Transistors 18 möglich. Da dieser Transistor 18 näherungsweise wie ein Emitterfolger wirkt, kann ohne eine weitere Treiberschaltung bereits eine externe niederohmige Last getrieben werden. Wenn jedoch die Schwingung an eine niederohmige oder aber auch stark kapazitive Last ausgekoppelt werden soll oder eine weitere eine entsprechende wechselstrommäßig niederohmige Impedanz aufweisende Last zusätzlich getrieben werden soll, dann ist eine entsprechende Treiberschaltung 23 mit einem weiteren Transistor 24 in Kollektorschaltung vorgesehen. Die Basis dieses Transistors 24 ist mit dem Emitter des Transistors 18 verbunden, der Kollektor mit der Versorgungsspannung und der Emitter über einen Emitterwiderstand 25 mit Masse. Der Emitter dieses Transistors 24 ist mit dem Anschluß 15 verbunden, an den die externe zu treibende niederohmige und auch stark kapazitive Last angeschlossen ist. Der Widerstandswert des Emitterwiderstandes 25 ist beispielsweise derart bemessen, daß er größer als die Kollektorwiderstände 19, 20 und kleiner als die Emitterwiderstände 21, 22 ist. Im Ausführungsbeispiel wurde ein Widerstandswert von 4,7 kOhm gewählt. Grundsätzlich jedoch wird dieser Widerstandswert in geeigneter Weise so dimensioniert, daß sich für den Transistor 24 ein Arbeitspunkt in der Weise einstellt, daß der dynamische Emitterausgangswiderstand in der Regel nicht größer als der der Last ist.

Die am Emitter des Transistors 18 auskoppelbare Oszillatorspannung $U_{L1}$ ist über Anschluß 30 und die am Emitter des Transistors 24 auskoppelbare Oszillatorspannung $U_{L2}$ ist über Anschluß 15 herausgeführt.

Bei einer Versorgungsspannung, die zwischen ca. 4,0 bis 12 V zulässig ist, hat sich gezeigt, daß die Frequenzänderung in Abhängigkeit der Versorgungsspannung relativ gering ist. Bei ca. 13 MHz tritt eine Änderung von nur 1 kHz pro Volt auf. Die Last kann dabei niederohmig sein und Kapazitäten aufweisen, die üblicherweise von Mikroprozessoren, CCD's etc. erreicht werden. Dies sind Werte von etwa 30 pF.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung in ihren verschiedenen Ausführungsformen wesentlich sein.

## Ansprüche

1. Oszillator mit zwei unmittelbar kreuzgekoppelten Invertierern, die je ein Stromkanal eines Transistors zwischen einem ersten und einem zweiten Widerstand angeordnet enthalten, wobei parallel zu einem der Widerstände in einem der Invertierer ein frequenzbestimmendes Element angeordnet ist,
dadurch gekennzeichnet, daß an einem nicht-invertierenden Ausgang des anderen Invertierers ein Oszillatorsignal $U_{L1}$ auskoppelbar ist.

2. Oszillator nach Anspruch 1, dadurch gekennzeichnet, daß eine Treiberschaltung (23) mit einem Eingang mit dem genannten, nicht-invertierenden Ausgang verbunden ist zum Auskoppeln eines weiteren Ozillatorsignals $U_{L2}$.

3. Oszillator nach Anspruch 1, dadurch gekennzeichnet, daß das frequenzbestimmende Element eine der nächsten Komponenten enthält: einen Schwingquarz (12), einen LC-Schwingkreis.

4. Oszillator nach Anspruch 1, dadurch gekennzeichnet, daß für jeden der Invertierer ein Quotient aus dem mit dem invertierenden Ausgang verbundenen Widerstand und dem mit dem nicht-invertierenden Ausgang verbundenen Widerstand kleiner ist als eins.

5. Oszillator nach Anspruch 4, dadurch gekennzeichnet, daß ein in seiner Kapazität veränderlicher Kondensator (16) in einer Reihenschaltung dem Schwingquarz (12) zugeordnet ist, der über mindestens einen äußeren Anschluß (13) mit der Schaltung (10) verbunden ist.